# EUROPÄISCHE PATENTSCHRIFT

(11) **EP 0 571 862 B1**
(45) Veröffentlichungstag und Bekanntmachung des Hinweises auf die Patenterteilung: **25.01.1995**
(21) Anmeldenummer: 93108020.4
(22) Anmeldetag: 17.05.1993
(51) Int. Cl.: H05K 7/20, H01L 23/42, H01L 23/495, H01L 21/60, H05K 3/32

(54) **Einbausystem für auf Leiterplatten montierte, hochintegrierte, gehäuselose Bausteine**
Mounting system for highly integrated and caseless components, mounted on printed circuit boards
Système de montage pour composants fortement intégrés et sans boîtier, montés sur plaques à circuits imprimés

(30) Priorität: 27.05.1992 DE 4217598
(43) Veröffentlichungstag der Anmeldung: 01.12.1993
(73) Patentinhaber: Siemens Nixdorf Informationssysteme Aktiengesellschaft, 33102 Paderborn (DE)
(72) Erfinder: Bachl, Johann, W-8000 München 19 (DE)
(74) Vertreter: Fuchs, Franz-Josef, Dr.-Ing.

(56) Entgegenhaltungen:
- EP-A- 0 435 586
- EP-A- 0 439 825
- EP-A- 0 484 320
- US-A- 5 000 256

## Beschreibung

### Einbausystem für auf Leiterplatten montierte, hochintegrierte, gehäuselose Bausteine

Die Erfindung betrifft ein Einbausystem für auf Leiterplatten montierte, hochintegrierte, gehäuselose Bausteine.

Bei hochintegrierten gehäuselosen Bausteinen mit einer Pinzahl > 500 und einer Verlustleistung > 50 Watt fällt pro Flächeneinheit eine erhebliche Wärmemenge an.

Aus EP-A-0435586 ist eine Kühlvorrichtung bekannt, die einen mit Kühlflüssigkeit gefüllten Sack aufweist. Der Sack ist mit einer oberen Öffnung und mit einer unteren Öffnung versehen, wobei die obere Öffnung mit einem Kühlkörper verbunden ist und die untere Öffnung mit einer Membran abgedichtet ist, die sich der oberen Oberfläche eines intefrieten Schaltkreises anpaßt.

Aufgabe der vorliegenden Erfindung ist es, ein Einbausystem für auf Leiterplatten montierte, hochintegrierte, gehäuselose Bausteine mit optimaler Wärmeableitung und einfacher Montierbarkeit zu schaffen.

Zur Lösung dieser Aufgabe sieht die Erfindung gemäß Anspruch 1 vor, daß die Bausteine über flache Spider mit den zugehörigen Lötflächen der Leiterplatte verbunden sind und daß eine den Baustein umrundende und an dessen Oberfläche befestigte Membran mit ihrem anderen Ende mit einem oberhalb des Bausteins ebenfalls rundum laufendem Kühlblech verbunden ist, das mit einer Kühlplatte gut wärmeleitend kontaktiert ist, und daß sich in dem aus Kühlblech, Bausteinoberfläche und Membran gebildeten Hohlraum eine interte Kühlflüssigkeit befindet.

Durch diese Maßnahmen wird die Kühlflüssigkeit direkt an der einen Bauteileseite vorbei geleitet und dadurch eine umfassende wärmeableitung erzielt.

Eine erste Ausführungsform sieht vor, daß das Kühlblech mit seinem oberen Rand in in der Kühlplatte befindlichen Nuten, befestigt ist, und daß es an seiner Unterseite einen rechtwinkelig abgebogenen Rand aufweist, der als Halterung für das eine Ende der Membran dient.

Eine zweite Ausführungsform ergibt sich dadurch, daß das Kühlblech einen Hohlquader bildet, der mit seiner Oberseite am Kühlkörper gut wärmeleitend anliegt und der an seiner Unterseite eine kreisrunde Öffnung aufweist, deren Rand als Halterung für die Membran dient.

Um die Outerleadbondung zu vereinfachen, ist es vorteilhaft, daß die Leads des Spiders abwechselnd unterschiedlich lang und beide nach außen abgebogen sind und die jeweils benachbart liegenden Lötflecken auf der Leiterplatte zueinander längs versetzt angeordnet sind.

Eine andere Möglichkeit besteht darin, daß die Außenanschlüsse (Outerleads) des Spiders gleich lang und abwechselnd die einen Leadenden nach außen und die anderen Leadenden nach innen abgebogen sind und daß die jeweils benachbarten Lötflecken auf der Leiterplatte zueinander längs versetzt angeordnet sind.

Eine weitere Möglichkeit zur Montagevereinfachung besteht darin, daß der Spider zweilagig ausgebildet ist, daß alle Leads gleich lang sind, daß jedes zweite Lead durchkontaktiert ist, und daß abwechselnd das eine Leadende nach außen und das andere Leadende nach innen gebogen ist, und daß die benachbarten Lötflecken auf der Leiterplatte zueinander längs versetzt sind.

Eine zusätzliche Kühlwirkung kann damit erreicht werden, daß das Kühlmittel einen möglichst niedrigen Siedepunkt aufweist, so daß durch den Verdunstungs- und Kondensationsvorgang zusätzliche Kühlwirkung erzielt wird.

Anhand der Ausführungsbeispiele nach den Figuren 1 bis 7 wird die Erfindung näher erläutert. Es zeigen
- Figur 1: ein erstes Ausführungsbeispiel nach der Erfindung,
- Figur 2: einen Schnitt III/III durch Figur 1,
- Figur 3: ein zweites Ausführungsbeispiel nach der Erfindung,
- Figur 4: einen Schnitt IV/IV durch Figur 3.

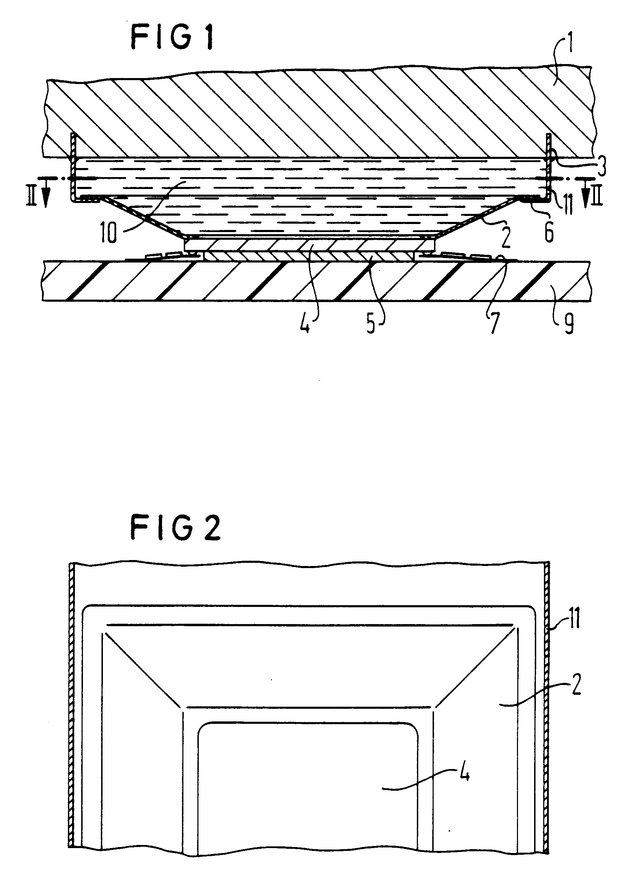

Bei einer Ausführungsform nach Figur 1 ist der Baustein 4 an seiner Oberfläche mit einer Membran 2 verbunden, die wiederum an das Kühlblech 11 geführt ist, das mit seinem oberen Rand in Nuten der Kühlplatte 1 eingreift. Der untere Rand des Kühlbleches ist rechtwinkelig abgebogen und dient dadurch als Auflage und Befestigungsmittel für die Membran 2. Der Baustein selbst ist über einen flachen, kaum gebogenen Spider 7 mit den Lötflecken der Leiterplatte 9 verbunden. In dem Hohlraum zwischen Kühlblech 11, Bausteinoberfläche und Kühlplatte 1 ist eine inerte Kühlflüssigkeit eingefüllt, die an den Bausteinen vorbeifließt, so daß die Bausteinoberfläche unmittelbar von der Kühlflüssigkeit umspült wird. Dadurch ist eine gute Wärmeableitung von Bauteiloberfläche zur Kühlplatte gewährleistet. Wird das Kühlmittel mit einem niedrigen Siedepunkt versehen, so kann eine zusätzliche Kühlwirkung durch den Siede/Kondensationsvorgang erreicht werden.

Die Membrane 2 ist entsprechend der äußeren Form des Bausteins 4 gestaltet, im vorliegenden Fall quadratisch und liegt mit seinem oberen Rand auf den abgewinkelten Teilen 6 des Kühlblechs 11 auf.

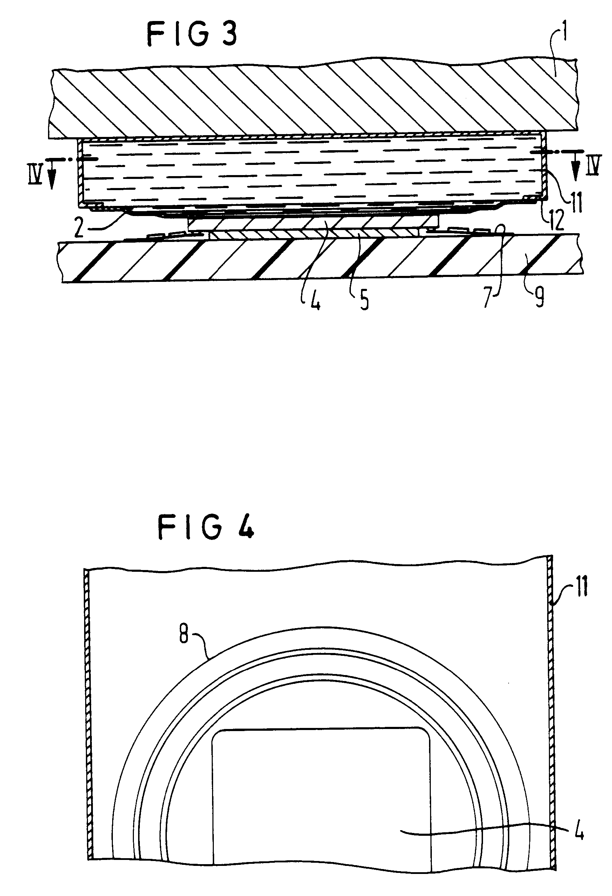

Eine andere Ausführungsform ist in Figur 3 gezeigt. Dort ist das Kühlblech zu einem Hohlquader geformt, der an seiner Unterseite eine kreisrunde Öffnung 8 aufweist. Der Baustein 4 ist über die Membran 2 mit dem quaderförmig ausgestalteten Kühlblech 11 verbunden, so daß sich wiederum ein Hohlraum 10 zwischen Kühlblech 11, Bausteinoberfläche und Membran 2 ergibt, der mit Kühlflüssigkeit gefüllt ist, die an den Bausteinen vorbeifließt. Der Baustein selbst ist mit einem flachen Spider 7 mit den Lötflecken der Leiterplatte 9 verbunden.

Figur 4 zeigt den Schnitt IV/IV durch die Figur 3.

Zur Vereinfachung der Bausteinmontage lassen sich die Outerleads 13, 14 des Spiders 7 unterschiedlich gestalten.

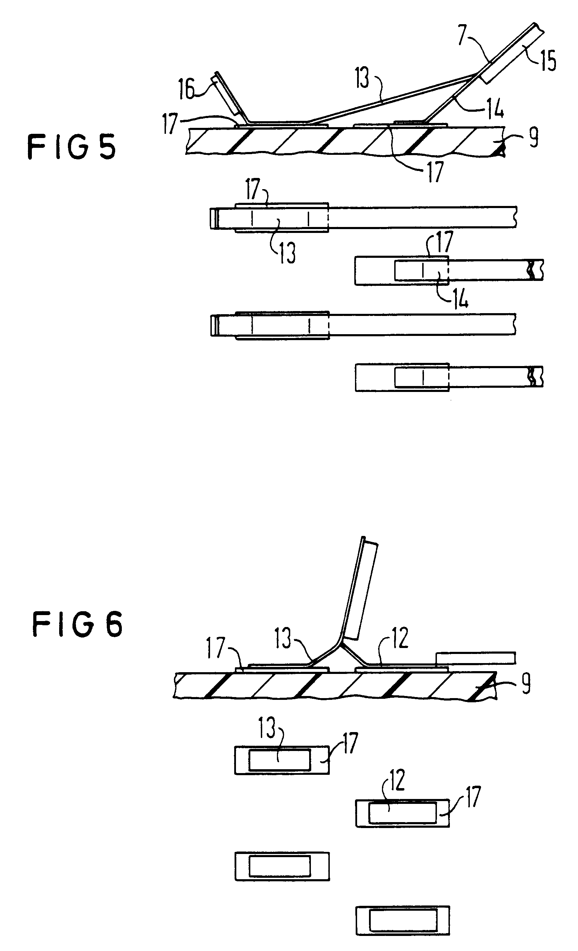

So ist in Figur 5 eine Ausführungsform dargestellt, bei der abwechselnd die ungeradzahligen Leads 13 länger sind als die geradzahligen Leads 14 oder umgekehrt und die jeweils benachbarten Pads 17 auf der Leiterplatte 9 sind gegeneinander rückversetzt angeordnet. Die einzelnen Leads sind beide nach vorn weisend abgebogen.

Eine andere Möglichkeit zur Vereinfachung der Befestigung derartiger Bausteine besteht darin, daß wie in Figur 6 dargestellt, zwar die Outerleads 13, 14 des Spiders 7 gleich lang ausgebildet sind, jedoch die ungeradzahligen Leads nach vorne und die geradzahligen Leads nach innen oder umgekehrt abgebogen sind.

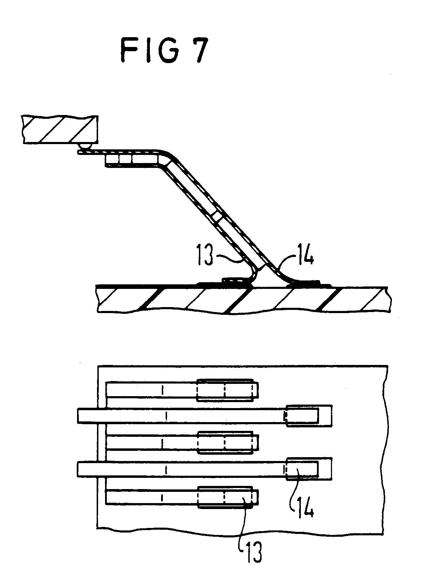

Eine andere Möglichkeit, einen längsversetzten Spider 7 aufzubauen ist, den Spider zweilagig auszubilden, wie in Figur 7 dargestellt und mit Durchkontaktierungen von jedem zweiten Lead zu versehen. Dabei sind die gleich langen Leads 13, 14 abwechselnd nach innen und nach außen gebogen und die Pads 17 auf der Leiterplatte 9 sind wieder rückwärts versetzt gegeneinander angeordnet.

## Patentansprüche

1. Einbausystem für auf Leiterplatten montierte hochintegrierte gehäuselose Bausteine, wobei die Bausteine (4) über flache Spider (7) mit den zugehörigen Lötflächen der Leiterplatte verbunden sind und eine den Baustein (4) umrundende und an dessen Oberfläche befestigte Membran (2) mit ihrem anderen Ende mit einem oberhalb des Bausteins (14) ebenfalls rundum laufendem Kühlblech (11) verbunden ist, das mit einer Kühlplatte (1) wärmeleitend kontaktiert ist, und wobei sich in dem aus Kühlblech (11), Bausteinoberfläche und Membran (2) gebildeten Hohlraum (10) eine inerte Kühlflüssigkeit befindet.

2. Einbausystem nach Anspruch 1, **dadurch gekennzeichnet**, daß das Kühlblech (11) mit seinem oberen Rand in in der Kühlplatte (1) befindlichen Nuten (3) befestigt ist, und daß es an seiner Unterseite einen rechtwinkelig abgebogenen Rand (6) aufweist, der als Halterung für das eine Ende der Membran (2) dient.

3. Einbausystem nach Anspruch 1, **dadurch gekennzeichnet**, daß das Kühlblech (11) einen Hohlquader bildet, der mit seiner Oberseite am Kühlkörper (1) gut wärmeleitend anliegt und der an seiner Unterseite eine kreisrunde Öffnung (8) aufweist, deren Rand (12) als Halterung für die Membran (2) dient.

4. Einbausystem nach einem der Ansprüche 1 bis 3, **dadurch gekennzeichnet**, daß die Außenanschlüsse (13) des Spiders (7) abwechselnd unterschiedlich lang und beide nach außen abgebogen sind und die jeweils benachbart liegenden Lötflecken auf der Leiterplatte (9) zueinander längs versetzt angeordnet sind.

5. Einbausystem nach einem der Ansprüche 1 bis 3, **dadurch gekennzeichnet**, daß die Außenanschlüsse (13) des Spiders (7) gleich lang und abwechselnd die einen Leadenden nach außen und die anderen Leadenden nach innen abgebogen sind und daß die jeweils benachbarten Lötflecken auf der Leiterplatte (9) zueinander längs versetzt angeordnet sind.

6. Einbausystem nach einem der Ansprüche 1 bis 3, **dadurch gekennzeichnet**, daß der Spider (7) zweilagig ausgebildet ist, daß alle Leads gleich lang sind, daß jedes zweite Lead durchkontaktiert ist, und daß abwechselnd das eine Leadende nach außen und das andere Leadende nach innen gebogen ist, und daß die benachbarten Lötflecken auf der Leiterplatte (9) zueinander längs versetzt sind.

7. Einbausystem nach einem der vorhergehenden Ansprüche, **dadurch gekennzeichnet**, daß die Kühlflüssigkeit einen niedrigen Siedepunkt aufweist und am Baustein vorbeiströmt.

## Claims

1. Packaging system for highly integrated unpackaged modules mounted on printed circuit boards, in which the modules (4) are connected via flat spiders (7) to the associated solder surfaces of the printed circuit board and a diaphragm (2) which surrounds the module (4) and is fastened to the surface thereof is connected with its other end to a cooling sheet (11) which likewise runs round above the module (4) and is contacted in a thermally conductive fashion to a cooling plate (1), and in which an inert cooling liquid is located in the cavity (10) formed from the cooling sheet (11), module surface and diaphragm (2).

2. Packaging system according to Claim 1, characterized in that the cooling sheet (11) is fastened by its upper edge in grooves (3) located in the cooling plate (1), and in that it has on its underside an edge (6) which is bent away at a right angle and serves as a holder for one end of the diaphragm (2).

3. Packaging system according to Claim 1, characterized in that the cooling sheet (11) forms a hollow cuboid which bears with its top side against the heat sink (1) in an effectively thermally conductive fashion and which has on its underside a circular opening (8) whose edge (12) serves as a holder for the diaphragm (2).

4. Packaging system according to one of Claims 1 to 3, characterized in that the outer leads (13) of the spider (7) are alternately of different length and are both bent away outwards and the pads respectively situated adjacently on the printed circuit board (9) are arranged longitudinally offset relative to one another.

5. Packaging system according to one of Claims 1 to 3, characterized in that the outer leads (13) of the spider (7) are of equal length and alternately some leads are bent away outwards and the other leads are bent away inwards, and in that the respectively adjacent pads are arranged on the printed circuit board (9) longitudinally offset relative to one another.

6. Packaging system according to one of Claims 1 to 3, characterized in that the spider (7) is constructed in two layers, in that all the leads are of equal length, in that each second lead is plated-through, and in that alternately one lead is bent outwards and the other lead is bent inwards, and in that the adjacent pads are offset longitudinally relative to one another on the printed circuit board (9).

7. Packaging system according to one of the preceding claims, characterized in that the cooling liquid has a low boiling point and flows past the module.

## Revendications

1. Système de montage pour des composants sans boîtier, à haute densité d'intégration montés sur des plaquettes à circuits imprimés, les composants (4) étant reliés par l'intermédiaire de croisillons plats (7) aux surfaces associées de brasage des plaquettes à circuits imprimés et une membrane (2), qui s'étend sur la périphérie du composant (4) et est fixée sur sa surface, étant reliée par son autre extrémité à une tôle de refroidissement (11), qui s'étend également sur toute la périphérie et au-dessus du composant (4) et qui est en contact conducteur de chaleur avec une plaque de refroidissement (1), et un liquide de refroidissement inerte se trouve dans la cavité (10) formée entre la tôle de refroidissement (11), la surface du composant et la membrane (2).

2. Système de montage suivant la revendication 1, caractérisé par le fait que la tôle de refroidissement (11) est fixée par son bord supérieur dans des rainures (3) situées dans la plaque de refroidissement (1), et possède au niveau de sa face inférieure, un bord (6), qui est replié à angle droit et qui sert de fixation pour l'une des extrémités de la membrane (2).

3. Système de montage suivant la revendication 1, caractérisé par le fait que la tôle de refroidissement (11) forme un parallélépipède creux, qui s'applique par sa face supérieure contre le corps de refroidissement (1) en établissant une bonne conduction de la chaleur et qui possède, à sa face inférieure, une ouverture circulaire (8), dont le bord (12) sert de fixation pour la membrane (2).

4. Système de montage suivant l'une des revendications 1 à 3, caractérisé par le fait que les bornes extérieures (13) du croisillon (7) ont des longueurs alternativement différentes et sont repliées toutes deux vers l'extérieur, et les plages de brasage, qui sont respectivement voisines, sont disposées sur la plaquette à circuits imprimés (9) en étant décalées longitudinalement les unes par rapport aux autres.

5. Système de montage suivant l'une des revendications 1 à 3, caractérisé par le fait que les bornes extérieures (13) du croisillon (7) possèdent la même longueur et alternativement des premières extrémités des bornes sont repliées vers l'extérieur et les autres extrémités des bornes sont repliées vers l'intérieur, et les plages de brasage respectivement voisines sont disposées sur la plaquette à circuits imprimés (9) en étant décalées longitudinalement les unes par rapport aux autres.

6. Système de montage suivant l'une des revendications 1 à 3, caractérisé par le fait que le croisillon (7) est formé de deux couches, toutes les bornes ont la même longueur, chaque seconde borne est reliée selon un contact traversant et, alternativement, une extrémité de borne est repliée vers l'extérieur et l'autre extrémité de borne est repliée vers l'intérieur et les plages de brasage voisines sont disposées sur la plaquette à circuits imprimés en étant décalées longitudinalement les unes par rapport aux autres.

7. Système de montage suivant l'une des revendications précédentes, caractérisé par le fait que le liquide de refroidissement possède un point d'ébullition bas et passe sur le composant.
